# EUROPEAN PATENT APPLICATION

(11) **EP 4 498 370 A1**
(43) Date of publication of application: **29.01.2025**
(21) Application number: 23914181.5
(22) Date of filing: 23.04.2023
(51) Int. Cl.: G11C 11/4063

(54) **CONTROL CIRCUIT, CONTROL METHOD, AND MEMORY**

(30) Priority: 05.01.2023 CN 202310013626
(71) Applicant: CXMT Corporation, Hefei, Anhui 230601 (CN)
(72) Inventor: ZHANG, Zhiqiang, Hefei, Anhui 230601 (CN)
(74) Representative: Gulde & Partner
(86) International application number: PCT/CN2023/090028
(87) International publication number: WO 2024/146030

(57) **Abstract**

Embodiments of the present disclosure provide a control circuit, a control method, and a memory. The control circuit includes: a flag signal generation module, configured to generate a command/address inversion flag signal based on a command/address control signal and an initial inversion flag signal; an input processing module, configured to generate a first intermediate command/address signal based on the command/address control signal and an initial command/address signal; and a logic decoding module, configured to: receive the first intermediate command/address signal and the command/address inversion flag signal, and generate a power down mode entry signal or a power down mode exit signal based on the command/address inversion flag signal and the first intermediate command/address signal.

## Description

### CROSS-REFERENCE TO RELATED APPLICATIONS

The present disclosure claims priority to Chinese Patent Application No. 202310013626.5, filed with the China National Intellectual Property Administration on January 5, 2023 and entitled "CONTROL CIRCUIT, CONTROL METHOD, AND MEMORY", which is incorporated herein by reference in its entirety.

### TECHNICAL FIELD

The present disclosure relates to but is not limited to a control circuit, a control method, and a memory.

### BACKGROUND

A dynamic random access memory (DRAM) has a power down mode. The memory enters the power down mode after a power down mode entry signal is received. In the power down mode, many circuits in the memory stop working, and the entire memory is in a low power state. After a power down mode exit signal is received, the memory exits the power down mode, and resumes a normal working state. However, when command/address inversion exists, the circuit may encounter a problem that decoding cannot be normally performed to obtain the power down mode exit signal.

### SUMMARY

Embodiments of the present disclosure provide a control circuit, a control method, and a memory.

According to a first aspect, an embodiment of the present disclosure provides a control circuit, including:
a flag signal generation module, configured to: receive a command/address control signal and an initial inversion flag signal, and generate a command/address inversion flag signal based on the command/address control signal and the initial inversion flag signal;
an input processing module, configured to: receive the command/address control signal and an initial command/address signal, and generate a first intermediate command/address signal based on the command/address control signal and the initial command/address signal; and
a logic decoding module, separately connected to the flag signal generation module and the input processing module, and configured to: receive the first intermediate command/address signal and the command/address inversion flag signal, and generate a power down mode entry signal or a power down mode exit signal based on the command/address inversion flag signal and the first intermediate command/address signal.

In some embodiments, the flag signal generation module is configured to: control the command/address inversion flag signal to be in a first level state when the command/address control signal is in an enabled state, and determine a level state of the command/address inversion flag signal based on the initial inversion flag signal when the command/address control signal is in a disabled state.

It indicates that a chip including the control circuit is in a power down mode when the command/address control signal is in an enabled state, or it indicates that a chip including the control circuit is in a normal mode when the command/address control signal is in a disabled state.

In some embodiments, the flag signal generation module includes a first logic module and a second logic module.

The first logic module is configured to: receive the command/address control signal, and perform inversion processing on the command/address control signal to obtain a first inverted signal.

The second logic module is configured to: receive the first inverted signal and the initial inversion flag signal, perform logical processing on the first inverted signal and the initial inversion flag signal, generate and output, in the power down mode, the command/address inversion flag signal in a first level state, and generate and output, in the normal mode, the command/address inversion flag signal in the same level state as the initial inversion flag signal.

In some embodiments, the first logic module includes a first NOT gate, and the second logic module includes a first NAND gate and a second NOT gate.

An input terminal of the first NOT gate is configured to receive the command/address control signal, an output terminal of the first NOT gate is connected to a first input terminal of the first NAND gate, a second input terminal of the first NAND gate is configured to receive the initial inversion flag signal, an output terminal of the first NAND gate is connected to an input terminal of the second NOT gate, and an output terminal of the second NOT gate is configured to output the command/address inversion flag signal.

In some embodiments, the input processing module is configured to: control the first intermediate command/address signal to be in a second level state when the command/address control signal is in an enabled state, and determine a level state of the first intermediate command/address signal based on the initial command/address signal when the command/address control signal is in a disabled state.

It indicates that the control circuit is in the power down mode when the command/address control signal is in an enabled state, or it indicates that the control circuit is in the normal mode when the command/address control signal is in a disabled state.

In some embodiments, the initial command/address signal includes N bits of initial command/address sub-signals, the first intermediate command/address signal includes N bits of first intermediate command/address sub-signals, N is a positive integer, the input processing module includes N input processing sub-modules, and the N input processing sub-modules are respectively in a one-to-one correspondence with both the N bits of initial command/address sub-signals and the N bits of first intermediate command/address sub-signals.

Each of the input processing sub-modules is configured to: receive the command/address control signal and the corresponding initial command/address sub-signal, and generate the corresponding first intermediate command/address sub-signal based on the command/address control signal and the corresponding initial command/address sub-signal.

In some embodiments, each of the input processing sub-modules includes a third logic module and a buffer module.

The third logic module is configured to: receive the command/address control signal and the corresponding initial command/address sub-signal, and perform logical processing on the command/address control signal and the corresponding initial command/address sub-signal to generate a third intermediate command/address sub-signal.

The buffer module is configured to perform drive enhancement processing on the third intermediate command/address sub-signal to obtain the first intermediate command/address sub-signal.

In the power down mode, the first intermediate command/address sub-signal in a second level state is generated and output, and in the normal mode, the first intermediate command/address sub-signal in the same level state as the initial command/address sub-signal is generated and output.

In some embodiments, the third logic module includes a third NOT gate, a fourth NOT gate, and a second NAND gate.

An input terminal of the third NOT gate is configured to receive the command/address control signal, and an output terminal of the third NOT gate is connected to a first input terminal of the second NAND gate.

An input terminal of the fourth NOT gate is configured to receive the corresponding initial command/address sub-signal, and an output terminal of the fourth NOT gate is connected to a second input terminal of the second NAND gate.

An output terminal of the second NAND gate is configured to output the third intermediate command/address sub-signal.

In some embodiments, the third logic module includes a fifth NOT gate, a tri-state gate, and a P-type transistor.

An input terminal of the fifth NOT gate is configured to receive the command/address control signal, an input terminal of the tri-state gate is configured to receive the corresponding initial command/address sub-signal, both a control terminal of the tri-state gate and an output terminal of the fifth NOT gate are connected to a gate terminal of the P-type transistor, a first terminal of the P-type transistor is connected to a power supply terminal, a second terminal of the P-type transistor and an output terminal of the tri-state gate are connected as an output terminal of the third logic module, and are configured to output the corresponding third intermediate command/address sub-signal.

In some embodiments, the buffer module includes an even quantity of sixth NOT gates connected in series.

In some embodiments, the logic decoding module includes a logic control module, a control terminal of the logic control module is connected to an output terminal of the flag signal generation module, and an input terminal of the logic control module is connected to an output terminal of the input processing module.

The logic control module is configured to: receive the first intermediate command/address signal and the command/address inversion flag signal, and perform logical processing based on the command/address inversion flag signal and the first intermediate command/address signal to generate a second intermediate command/address signal.

In some embodiments, the logic control module is configured to: control the second intermediate command/address signal to be in the same level state as the first intermediate command/address signal when the command/address inversion flag signal is in a first level state, or control the second intermediate command/address signal to be in the opposite level state to the first intermediate command/address signal when the command/address inversion flag signal is in a second level state.

In some embodiments, the first intermediate command/address signal includes N bits of first intermediate command/address sub-signals, the second intermediate command/address signal includes N bits of second intermediate command/address sub-signals, N is a positive integer, the logic control module includes N logic control sub-modules, the N logic control sub-modules are respectively in a one-to-one correspondence with both the N bits of first intermediate command/address sub-signals and the N bits of second intermediate command/address sub-signals, and each of the logic control sub-modules includes a seventh NOT gate and a selector.

Both an input terminal of the seventh NOT gate and a first input terminal of the selector are configured to receive the corresponding first intermediate command/address sub-signal, an output terminal of the seventh NOT gate is connected to a second input terminal of the selector, a control terminal of the selector is configured to receive the command/address inversion flag signal, and an output terminal of the selector is configured to output the corresponding second intermediate command/address sub-signal.

In some embodiments, the logic decoding module further includes a first sampling module and a decoding module, an input terminal of the first sampling module is connected to an output terminal of the logic control module, and an input terminal of the decoding module is connected to an output terminal of the first sampling module.

The first sampling module is configured to perform sampling processing on the second intermediate command/address signal to obtain a first sampled signal.

The decoding module is configured to perform decoding processing on the first sampled signal to obtain the power down mode exit signal.

In some embodiments, the second intermediate command/address signal includes N bits of second intermediate command/address sub-signals, the control circuit further includes a control signal generation module, the control signal generation module is connected to the logic control module and is configured to receive a target command/address signal, the target command/address signal is an nth bit of second intermediate command/address sub-signal in the N bits of second intermediate command/address sub-signals, and n is a positive integer less than or equal to N.

The control signal generation module is further configured to: receive a clock signal, the power down mode entry signal, and the power down mode exit signal, perform sampling processing on the target command/address signal based on the clock signal to generate a second sampled signal, and perform logical processing based on the second sampled signal, the power down mode entry signal, and the power down mode exit signal to generate the command/address control signal.

In some embodiments, the control signal generation module is configured to: control the command/address control signal to be in an enabled state when in the power down mode, and control the command/address control signal to be in a disabled state when in the normal mode.

In some embodiments, the control signal generation module includes a second sampling module and a fourth logic module.

The second sampling module is configured to: receive the target command/address signal and the clock signal, and perform sampling processing on the target command/address signal based on the clock signal to obtain the second sampled signal.

The fourth logic module is configured to: receive the power down mode entry signal, the power down mode exit signal, and the second sampled signal, generate a power down mode enable signal based on the power down mode entry signal and the power down mode exit signal, and perform a logical operation based on the second sampled signal and the power down mode enable signal to generate the command/address control signal.

The power down mode enable signal in a valid state is generated when the power down mode entry signal is in a valid state, so that the command/address control signal is in an enabled state; and the power down mode enable signal in an invalid state is generated when the power down mode exit signal is in a valid state, so that the command/address control signal is in a disabled state.

In some embodiments, the second sampling module includes a first D flip-flop, and the fourth logic module includes a latch module and a third NAND gate.

An input terminal of the first D flip-flop is configured to receive the target command/address signal, a clock terminal of the first D flip-flop is configured to receive the clock signal, an output terminal of the first D flip-flop is connected to a first input terminal of the third NAND gate, and the output terminal of the first D flip-flop is configured to output the second sampled signal.

A first input terminal of the latch module is configured to receive the power down mode entry signal, a second input terminal of the latch module is configured to receive the power down mode exit signal, and an output terminal of the latch module is configured to output the power down mode enable signal.

A second input terminal of the third NAND gate is connected to the output terminal of the latch module, and an output terminal of the third NAND gate is configured to output the command/address control signal.

In some embodiments, the latch module includes a fourth NAND gate, a fifth NAND gate, and an eighth NOT gate.

A first input terminal of the fourth NAND gate is configured to receive the power down mode entry signal, a second input terminal of the fourth NAND gate is connected to an output terminal of the fifth NAND gate, an output terminal of the fourth NAND gate is separately connected to a first input terminal of the fifth NAND gate and an input terminal of the eighth NOT gate, a second input terminal of the fifth NAND gate is configured to receive the power down mode exit signal, and an output terminal of the eighth NOT gate is connected to the second input terminal of the third NAND gate.

According to a second aspect, an embodiment of the present disclosure provides a control method, including the steps as follows.

A command/address control signal and an initial inversion flag signal are received by a flag signal generation module, and a command/address inversion flag signal is generated based on the command/address control signal and the initial inversion flag signal.

The command/address control signal and an initial command/address signal are received by an input processing module, and a first intermediate command/address signal is generated based on the command/address control signal and the initial command/address signal.

The first intermediate command/address signal and the command/address inversion flag signal are received by a logic decoding module, and a power down mode entry signal or a power down mode exit signal is generated based on the command/address inversion flag signal and the first intermediate command/address signal.

According to a third aspect, an embodiment of the present disclosure provides a memory, including the control circuit according to any one embodiment of the first aspect.

### BRIEF DESCRIPTION OF DRAWINGS

FIG. 1 is a schematic diagram of structural composition of a control circuit according to an embodiment of the present disclosure;
FIG. 2 is a schematic diagram of structural composition of a flag signal generation module according to an embodiment of the present disclosure;
FIG. 3 is a schematic diagram of structural composition of an input processing module according to an embodiment of the present disclosure;
FIG. 4 is a schematic diagram of structural composition of an input processing sub-module according to an embodiment of the present disclosure;
FIG. 5 is a schematic diagram of structural composition of another input processing sub-module according to an embodiment of the present disclosure;
FIG. 6 is a schematic diagram of structural composition of still another input processing sub-module according to an embodiment of the present disclosure;
FIG. 7 is a schematic diagram of structural composition of another control circuit according to an embodiment of the present disclosure;
FIG. 8A is a schematic diagram of structural composition of a logic control module according to an embodiment of the present disclosure;
FIG. 8B is a schematic diagram of structural composition of another logic control module according to an embodiment of the present disclosure;
FIG. 9 is a schematic diagram of structural composition of a control signal generation module according to an embodiment of the present disclosure;
FIG. 10 is a schematic diagram of signal timing according to an embodiment of the present disclosure;
FIG. 11 is a schematic flowchart of a control method according to an embodiment of the present disclosure; and
FIG. 12 is a schematic diagram of structural composition of a memory according to an embodiment of the present disclosure.

### DESCRIPTION OF EMBODIMENTS

The following clearly describes the technical solutions in the embodiments of the present disclosure with reference to the accompanying drawings in the embodiments of the present disclosure. It may be understood that a specific embodiment described herein is merely intended to explain related disclosure, but is not intended to limit the present disclosure. In addition, it should be further noted that, for ease of description, only a part related to the related disclosure is shown in the accompanying drawings.

Unless otherwise defined, all technical and scientific terms included herein have the same meanings as those generally understood by a person skilled in the technical field of the present disclosure. The terms included herein are merely intended to describe the embodiments of the present disclosure, and are not intended to limit the present disclosure.

The following description relates to "some embodiments" describing a subset of all the possible embodiments. However, it may be understood that "some embodiments" may be the same or different subsets of all the possible embodiments, and may be combined with each other in the case of no conflict.

It should be noted that the term "first\second\third" in the embodiments of the present disclosure is merely intended to distinguish between similar objects, and does not represent specific sorting for the objects. It may be understood that "first\second\third" may be interchanged for a specific sequence or order if allowed, so that the embodiments of the present disclosure described herein can be implemented in a sequence other than those shown or described herein.

Before the embodiments of the present disclosure are further described in detail, nouns and terms in the embodiments of the present disclosure are first described. The nouns and the terms in the embodiments of the present disclosure are applicable to the following explanations:
command/address (CA);
power down mode;
power down mode exit signal (Power Down Exit Command, PDX CMD/PDX);
power down mode entry signal (Power Down Entry Command, PDE CMD/PDE/PDN CMD/PDN);
double data rate (DDR);
command/address inversion (CAI);
dynamic random access memory (DRAM);
clock enable signal (CKE);
chip select signal (CS);
bank;
P-type metal oxide semiconductor field effect transistor (Positive channel Metal Oxide Semiconductor field effect transistor, PMOS transistor/P-type transistor);
N-type metal oxide semiconductor field effect transistor (Negative channel Metal Oxide Semiconductor field effect transistor, NMOS transistor/N-type transistor);
D flip-flop (DFF).

For command/address inversion, logic levels on all CA signals are inverted within a DRAM when a CAI pin is connected to VDDQ. Generally, the CAI pin needs to be connected to VSSQ if CA inversion is not required. IDD2P refers to leakage current existing when the DRAM is in an idle state, a CKE signal and a CS signal are at a low level, a data line remains unchanged, and a command/address line signal works normally. IDD3P refers to leakage current existing when one or more banks in the DRAM are activated, a CKE signal and a CS signal are at a low level, a data line remains unchanged, and a command/address line signal works normally.

To reduce power consumption of IDD2P/IDD3P, all CA buffers need to be controlled to be disabled in a power down mode. To detect PDX CMD, an output of the CA buffer needs to be at a high level when the CA buffer is disabled. In DDR5, there is a CAI function. It is necessary to consider that PDX CMD may be further obtained normally through decoding when CAI is enabled.

Table 1 shows a decoding table between the CA signal and both PDE and PDX.

**Table 1**

| | CS_n | CA0 | CA1 | CA2 | CA3 | CA4 |
|---|---|---|---|---|---|---|
| PDE | L | H | H | H | L | H |
| PDX | L | H | H | H | H | H |

As shown in Table 1, L represents a low level, and H represents a high level. A power down mode exit signal PDX may be obtained through decoding when CS_n is at a low level and CA0 to CA4 are all at a high level. A power down mode entry signal PDE may be obtained through decoding when CS_n is at a low level and CA3 is at a low level, CA0 to CA2 and CA4 are at a high level, and CA10 is also at a high level.

Based on this, the embodiments of the present disclosure provide a control circuit, including: a flag signal generation module, configured to: receive a command/address control signal and an initial inversion flag signal, and generate a command/address inversion flag signal based on the command/address control signal and the initial inversion flag signal; an input processing module, configured to receive the command/address control signal and an initial command/address signal, and generate a first intermediate command/address signal based on the command/address control signal and the initial command/address signal; and a logic decoding module, separately connected to the flag signal generation module and the input processing module, and configured to: receive the first intermediate command/address signal and the command/address inversion flag signal, and generate a power down mode entry signal or a power down mode exit signal based on the command/address inversion flag signal and the first intermediate command/address signal. In this way, the command/address control signal is configured to separately control the command address/inversion flag signal output by the flag signal generation module and the first intermediate command/address signal output by the input processing module. This ensures that the logic decoding module can successfully obtain a required command signal through decoding regardless of whether the initial inversion flag signal is enabled, especially in a power down mode, ensures that the power down mode exit signal can be successfully obtained through decoding, to ensure that the circuit can successfully exit the power down mode, thereby ensuring normal working of the memory, and improving memory performance.

The embodiments of the present disclosure are described below in detail with reference to the accompanying drawings.

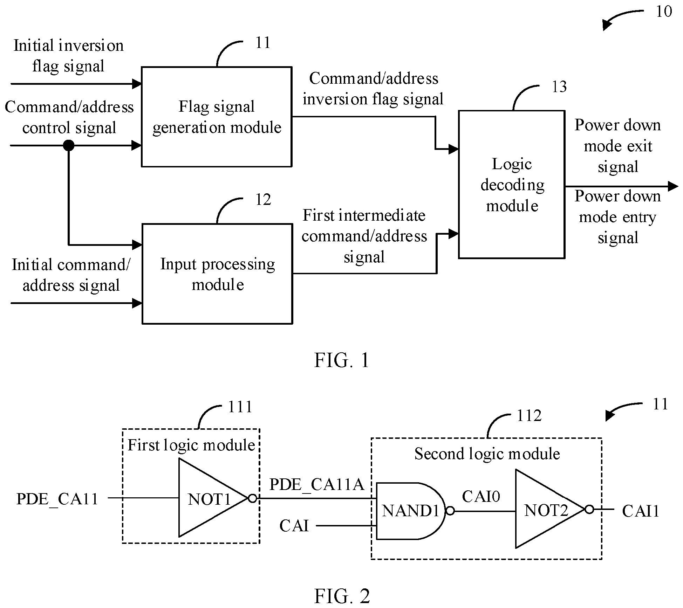

In an embodiment of the present disclosure, reference is made to FIG. 1, which is a schematic diagram of structural composition of a control circuit according to an embodiment of the present disclosure. As shown in FIG. 1, the control circuit 10 includes:
a flag signal generation module 11, configured to: receive a command/address control signal and an initial inversion flag signal, and generate a command/address inversion flag signal based on the command/address control signal and the initial inversion flag signal;
an input processing module 12, configured to: receive the command/address control signal and an initial command/address signal, and generate a first intermediate command/address signal based on the command/address control signal and the initial command/address signal; and
a logic decoding module 13, separately connected to the flag signal generation module 11 and the input processing module 12, and configured to: receive the first intermediate command/address signal and the command/address inversion flag signal, and generate a power down mode entry signal or a power down mode exit signal based on the command/address inversion flag signal and the first intermediate command/address signal.

It should be noted that the control circuit 10 provided in this embodiment of the present disclosure may be applied to a memory, such as a DRAM or another type of memory, to ensure that the power down mode exit signal, the power down mode entry signal, and another command signal can be successfully obtained through decoding, especially in a power down mode, ensure that the power down mode exit signal can be successfully obtained through decoding, so that the circuit exits the power down mode.

As shown in FIG. 1, the control circuit 10 includes the flag signal generation module 11, the input processing module 12, and the logic decoding module 13. An enable terminal of the flag signal generation module 11 is configured to receive the command/address control signal. An input terminal of the flag signal generation module 11 is configured to receive the initial inversion flag signal. An output terminal of the flag signal generation module 11 is connected to a control terminal of the logic decoding module 13, and is configured to send the obtained command/address inversion flag signal to the logic decoding module 13.

An enable terminal of the input processing module 12 is configured to receive the command/address control signal. An input terminal of the input processing module 12 is configured to receive the initial command/address signal. An output terminal of the input processing module 12 is connected to an input terminal of the logic decoding module 13, and is configured to send the obtained first intermediate command/address signal to the logic decoding module 13.

The command/address control signal separately serves as enable signals of the flag signal generation module 11 and the input processing module 12, and is configured to control output states of the flag signal generation module 11 and the input processing module 12.

For the flag signal generation module 11, in some embodiments, the flag signal generation module 11 is configured to: control the command/address inversion flag signal to be in a first level state when the command/address control signal is in an enabled state, and determine a level state of the command/address inversion flag signal based on the initial inversion flag signal when the command/address control signal is in a disabled state.

It indicates that a chip including the control circuit is in a power down mode when the command/address control signal is in an enabled state, or it indicates that a chip including the control circuit is in a normal mode when the command/address control signal is in a disabled state.

For the input processing module 12, in some embodiments, the input processing module 12 is configured to: control the first intermediate command/address signal to be in a second level state when the command/address control signal is in an enabled state, and determine a level state of the first intermediate command/address signal based on the initial command/address signal when the command/address control signal is in a disabled state.

It indicates that the chip including the control circuit is in the power down mode when the command/address control signal is in an enabled state, or it indicates that the chip including the control circuit is in the normal mode when the command/address control signal is in a disabled state.

It should be noted that the command/address control signal controls the flag signal generation module 11 in the following manner: An output (namely, the command/address inversion flag signal) of the flag signal generation module 11 is set to a first level state when the command/address control signal is in an enabled state, that is, the initial inversion flag signal does not function at this time. The level state of the command/address inversion flag signal output by the flag signal generation module 11 is determined by the initial inversion flag signal when the command/address control signal is in a disabled state.

The command/address control signal controls the input processing module 12 in the following manner: An output (namely, the first intermediate command/address signal) of the input processing module 12 is set to a second level state when the command/address control signal is in an enabled state, that is, the initial command/address signal does not function at this time. The level state of the first intermediate command/address signal output by the input processing module 12 is determined by the initial command/address signal when the command/address control signal is in a disabled state.

That is, the memory is in the power down mode when the command/address control signal is in an enabled state. In the power down mode, signals output by the output terminals of both the flag signal generation module 11 and the input processing module 12 are not controlled by signals input into the input terminals of the flag signal generation module 11 and the input processing module 12, but are set to a fixed level state. The memory is in the normal mode when the command/address control signal is in a disabled state. In the normal mode, signals output by the output terminals of both the flag signal generation module 11 and the input processing module 12 are controlled by signals input into the input terminals of the flag signal generation module 11 and the input processing module 12.

In this way, in this embodiment of the present disclosure, the command/address control signal is configured to control level states of the signals output by the flag signal generation module 11 and the input processing module 12, to ensure that the command/address inversion flag signal and the first intermediate command/address signal can be correctly output either in the power down mode or in the normal mode, so that the logic decoding module can perform decoding processing based on the command/address inversion flag signal and the first intermediate command/address signal. In the power down mode, the power down mode exit signal can be successfully obtained through decoding. In the normal mode, the power down mode entry signal and another command signal can be successfully obtained through decoding. This ensures successful decoding of the command signal, and ensures that the memory can normally enter or exit the power down mode, so that the memory works normally, thereby improving memory performance.

In this embodiment of the present disclosure, the command/address control signal is described through an example in which logic 1 indicating a high level represents the enabled state and logic 0 indicating a low level represents the disabled state. However, the logic 0 indicating the low level may represent the enabled state and the logic 1 indicating the high level may represent the disabled state. This is not specifically limited herein. In addition, the first level state in this embodiment of the present disclosure generally refers to the logic 0 indicating the low level, and the second level state generally refers to the logic 1 indicating the high level.

FIG. 2 is a schematic diagram of structural composition of a flag signal generation module according to an embodiment of the present disclosure. As shown in FIG. 2, in some embodiments, the flag signal generation module 11 includes a first logic module 111 and a second logic module 112.

The first logic module 111 is configured to: receive the command/address control signal PDE_CA11, and perform inversion processing on the command/address control signal PDE_CA11 to obtain a first inverted signal PDE _CA11A.

The second logic module 112 is configured to: receive the first inverted signal PDE _CA11A and the initial inversion flag signal CAI, perform logical processing on the first inverted signal PDE _CA11A and the initial inversion flag signal CAI, generate and output, in the power down mode, the command/address inversion flag signal CAI1 in a first level state, and generate and output, in the normal mode, the command/address inversion flag signal CAI1 in the same level state as the initial inversion flag signal CAI.

It should be noted that, as shown in FIG. 2, in the flag signal generation module 11, an input terminal of the first logic module 111 serves as the enable terminal of the flag signal generation module 11, and is configured to: receive the command/address control signal PDE_CA11, perform inversion processing on the command/address control signal PDE_CA11 to obtain the first inverted signal PDE_CA11A, and output the first inverted signal PDE_CA11A from an output terminal of the first logic module 111.

A second input terminal of the second logic module 112 serves as the input terminal of the flag signal generation module 11, and is configured to receive the initial inversion flag signal CAI. A first input terminal of the second logic module 112 is connected to the output terminal of the first logic module 111, and is configured to receive the first inverted signal PDE _CA11A. An output terminal of the second logic module 112 serves as the output terminal of the flag signal generation module 11, and is configured to output the command/address inversion flag signal CAI1.

In the power down mode, the level state of the command/address inversion flag signal CAI1 output by the second logic module 112 is the first level state. In the normal mode, the level state of the command/address inversion flag signal CAI1 output by the second logic module 112 is the same as a level state of the initial inversion flag signal CAI.

To implement functions of the first logic module 111 and the second logic module 112, in some embodiments, as shown in FIG. 2, the first logic module 111 includes a first NOT gate NOT1, and the second logic module 112 includes a first NAND gate NAND1 and a second NOT gate NOT2.

An input terminal of the first NOT gate NOT1 is configured to receive the command/address control signal PDE_CA11, an output terminal of the first NOT gate NOT1 is connected to a first input terminal of the first NAND gate NAND1, a second input terminal of the first NAND gate NAND1 is configured to receive the initial inversion flag signal CAI, an output terminal of the first NAND gate NAND1 is connected to an input terminal of the second NOT gate NOT2, and an output terminal of the second NOT gate NOT2 is configured to output the command/address inversion flag signal CAI1.

It should be noted that, as shown in FIG. 2, in the first logic module 111, the input terminal of the first NOT gate NOT1 serves as the input terminal of the first logic module 111, and the output terminal of the first NOT gate NOT1 serves as the output terminal of the first logic module 111. The first NOT gate NOT1 performs inversion processing on the command/address control signal PDE_CA11 to obtain the first inverted signal PDE_CA11A. In the second logic module 112, the first input terminal of the first NAND gate NAND1 serves as the first input terminal of the second logic module 112, and is configured to receive the first inverted signal PDE_CA11A. The second input terminal of the first NAND gate NAND1 serves as the second input terminal of the second logic module 112, and is configured to receive the initial inversion flag signal CAI. The first NAND gate NNAD1 performs NAND logical processing on the first inverted signal PDE_CA1 1A and the initial inversion flag signal CAI to obtain a first NAND signal CAI0, and sends the first NAND signal to the second NOT gate NOT2. The output terminal of the second NOT gate NOT2 serves as the output terminal of the second logic module 112, and the second NOT gate NOT2 performs inversion processing on the first NAND signal CAI0 to obtain the command/address inversion flag signal CAI1.

In the power down mode, the command/address control signal PDE_CA11 is in an enabled state (a high level state), and the first inverted signal PDE_CA11A is in a low level state. In the second logic module 112, because the first inverted signal PDE_CA11A received by the first NAND gate NAND1 is in a low level state, a level state of the first NAND signal CAI0 output by the first NAND gate NAND1 is always a high level state (a second level state) regardless of the level state of the initial inversion flag signal CAI, so that the level state of the command/address inversion flag signal CAI1 obtained by performing inversion processing on the first NAND signal CAI0 is always a low level state (a first level state).

In the normal mode, the command/address control signal PDE_CA11 is in a disabled state (a low level state), and the first inverted signal PDE_CA11A is in a high level state. In the second logic module 112, because the first inverted signal PDE_CA11A received by the first NAND gate NAND1 is in a high level state, a level state of the first NAND signal CAI0 output by the first NAND gate NAND1 is opposite to the level state of the initial inversion flag signal CAI received by the first NAND gate NAND1, so that the level state of the command/address inversion flag signal CAI1 obtained by performing inversion processing on the first NAND signal CAI0 is the same as the level state of the initial inversion flag signal CAI.

In this way, in this embodiment of the present disclosure, a logic gate is utilized for design, to implement the following in the flag signal generation module 11: In the power down mode, the level state of the command/address inversion flag signal CAI1 is set to a first level state. In the normal mode, the level state of the command/address inversion flag signal CAI1 is the same as the level state of the initial inversion flag signal CAI.

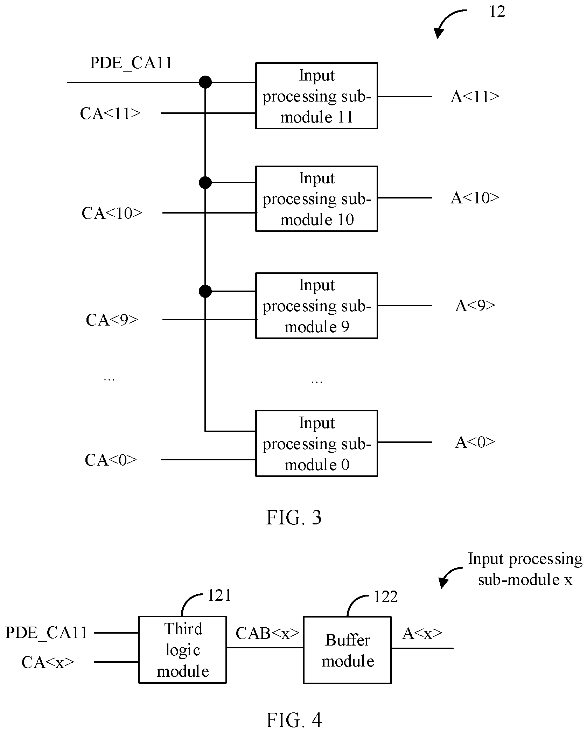

Further, in this embodiment of the present disclosure, the initial command/address signal and the first intermediate command/address signal each generally include not only a signal, but include a group of signals. In some embodiments, the initial command/address signal includes N bits of initial command/address sub-signals, the first intermediate command/address signal includes N bits of first intermediate command/address sub-signals, and N is a positive integer. Correspondingly, FIG. 3 is a schematic diagram of structural composition of an input processing module according to an embodiment of the present disclosure. As shown in FIG. 3, the input processing module 12 includes N input processing sub-modules, and the N input processing sub-modules are respectively in a one-to-one correspondence with both the N bits of initial command/address sub-signals and the N bits of first intermediate command/address sub-signals.

Each of the input processing sub-modules is configured to: receive the command/address control signal PDE_CA11 and the corresponding initial command/address sub-signal, and generate the corresponding first intermediate command/address sub-signal based on the command/address control signal PDE_CA11 and the corresponding initial command/address sub-signal.

It should be noted that, N=12 is taken as an example. As shown in FIG. 3, the initial command/address signal CA<11:0> includes a total of 12 bits of initial command/address sub-signals CA<0>, CA<1>, CA<2>, ..., and CA<11>, and the first intermediate command/address signal A<11:0> includes a total of 12 bits of first intermediate command/address sub-signals A<0>, A<1>, A<2>, ..., and A<11>. Correspondingly, the input processing module 12 includes 12 input processing sub-modules (or referred to as a CA buffer, which may be a high-speed buffer). Each of the input processing sub-modules receives the command/address control signal PDE_CA11 and 1 bit of corresponding initial command/address sub-signal, and generates 1 bit of corresponding first intermediate command/address sub-signal based on the received 1 bit of corresponding initial command/address sub-signal when the command/address control signal PDE_CA11 is in a disabled state, or directly sets the corresponding first intermediate command/address sub-signal to a second level state when the command/address control signal PDE_CA11 is in an enabled state.

For example, an input processing sub-module 11 is taken as an example. As shown in FIG. 3, an enable terminal of the input processing sub-module 11 receives the command/address control signal PDE_CA11, and an input terminal of the input processing sub-module 11 receives an initial command/address sub-signal CA<11>. In addition, drive enhancement processing is performed on the initial command/address sub-signal CA<11> when the command/address control signal PDE _CA11 is in a disabled state, to obtain a first intermediate command/address sub-signal A<11>, and output the first intermediate command/address sub-signal A<11> from an output terminal of the input processing sub-module 11. Alternatively, a first intermediate command/address sub-signal A<11> in a second level state is output when the command/address control signal PDE_CA11 is in an enabled state. The first intermediate command/address sub-signal output by the input processing sub-module may be in the same level state as the received initial command/address sub-signal. Working manners of the remaining input processing sub-modules are the same as the foregoing manner, and details are not described herein again.

FIG. 4 is a schematic diagram of structural composition of an input processing sub-module according to an embodiment of the present disclosure. For any input processing sub-module x, x is an integer greater than or equal to 0 and less than N. As shown in FIG. 4, the input processing sub-module x includes a third logic module 121 and a buffer module 122.

The third logic module 121 is configured to: receive the command/address control signal PDE_CA11 and the corresponding initial command/address sub-signal CA<x>, and perform logical processing on the command/address control signal PDE_CA11 and the corresponding initial command/address sub-signal CA<x> to generate a third intermediate command/address sub-signal CAB<x>.

The buffer module 122 is configured to perform drive enhancement processing on the third intermediate command/address sub-signal CAB<x> to obtain the first intermediate command/address sub-signal A<x>.

In the power down mode, the first intermediate command/address sub-signal A<x> in a second level state is generated and output, and in the normal mode, the first intermediate command/address sub-signal A<x> in the same level state as the initial command/address sub-signal CA<x> is generated and output.

It should be noted that, as shown in FIG. 4, a first input terminal of the third logic module 121 serves as an enable terminal of the input processing sub-module x, and is configured to receive the command/address control signal PDE_CA11. A second input terminal of the third logic module 121 serves as an input terminal of the input processing sub-module x, and is configured to receive an initial command/address sub-signal CA<x> corresponding to the input processing sub-module x. An output terminal of the third logic module 121 is connected to an input terminal of the buffer module 122.

The third logic module 121 performs inversion processing on the command/address control signal PDE_CA11 to obtain a second inverted signal PDE_CA11B. The third logic module 121 further performs inversion processing on the initial command/address sub-signal CA<x> to obtain an initial command/address inversion sub-signal CAA<x>. The third logic module 121 further performs logical processing on the second inverted signal PDE _CA11B and the initial command/address inversion sub-signal CAA<x> to obtain the third intermediate command/address sub-signal CAB<x>, and sends the third intermediate command/address sub-signal CAB<x> to the buffer module 122.

When the command/address control signal PDE_CA11 is in an enabled state, the memory is in the power down mode, and the third intermediate command/address sub-signal CAB<x> output by the third logic module 121 is in a second level state, so that the first intermediate command/address sub-signal A<x> obtained by the buffer module 122 by performing drive enhancement processing on the third intermediate command/address sub-signal CAB<x> is also in a second level state. When the command/address control signal PDE_CA11 is in a disabled state, the memory is in the normal mode, the third intermediate command/address sub-signal CAB<x> output by the third logic module 121 is in the same level state as the initial command/address sub-signal, so that the first intermediate command/address sub-signal A<x> obtained by the buffer module 122 by performing drive enhancement processing on the third intermediate command/address sub-signal CAB<x> is also in the same level state as the initial command/address sub-signal.

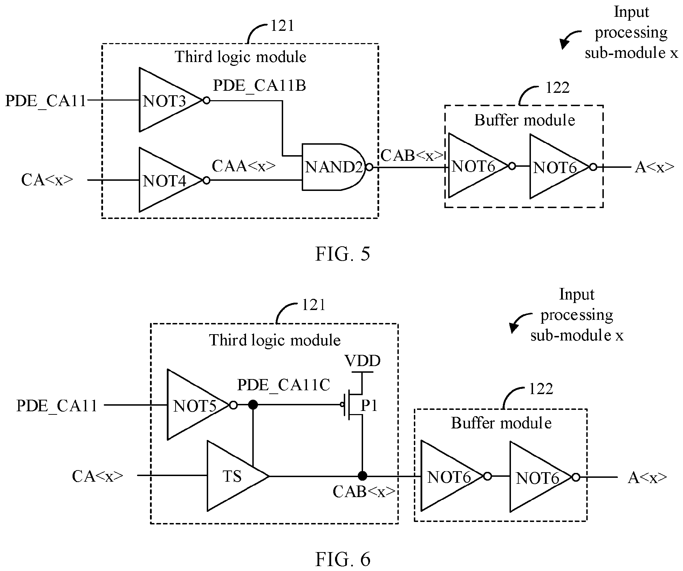

To implement a function of the third logic module 121, in a specific example, reference is made to FIG. 5, which is a schematic diagram of structural composition of another input processing sub-module according to an embodiment of the present disclosure. As shown in FIG. 5, the third logic module 121 includes a third NOT gate NOT3, a fourth NOT gate NOT4, and a second NAND gate NAND2.

An input terminal of the third NOT gate NOT3 is configured to receive the command/address control signal PDE CA11, and an output terminal of the third NOT gate NOT3 is connected to a first input terminal of the second NAND gate NAND2.

An input terminal of the fourth NOT gate NOT4 is configured to receive the corresponding initial command/address sub-signal CA<x>, and an output terminal of the fourth NOT gate NOT4 is connected to a second input terminal of the second NAND gate NAND2.

An output terminal of the second NAND gate NAND2 is configured to output the third intermediate command/address sub-signal CAB<x>.

It should be noted that, as shown in FIG. 5, the input terminal of the third NOT gate NOT3 serves as the first input terminal of the third logic module 121, and is configured to receive the command/address control signal PDE_CA11. The third NOT gate NOT3 performs inversion processing on the command/address control signal PDE_CA11 to obtain the second inverted signal PDE _CA11B. The output terminal of the third NOT gate NOT3 is connected to the first input terminal of the second NAND gate NAND2. The input terminal of the fourth NOT gate NOT4 serves as the second input terminal of the third logic module 121, and is configured to receive the initial command/address sub-signal CA<x> corresponding to the input processing sub-module x. The fourth NOT gate NOT4 performs inversion processing on the initial command/address sub-signal CA<x> to obtain the corresponding initial command/address inversion sub-signal CAA<x>. The output terminal of the fourth NOT gate NOT4 is connected to the second input terminal of the second NAND gate NAND2.

The first input terminal of the second NAND gate NAND2 is configured to receive the second inverted signal PDE_CA11B sent by the third NOT gate NOT3. The second input terminal of the second NAND gate NAND2 is configured to receive the initial command/address inversion sub-signal CAA<x> sent by the fourth NOT gate NOT4. The second NAND gate NAND2 performs NAND logical processing on the second inverted signal PDE_CA11B and the initial command/address inversion sub-signal CAA<x> to obtain the third command/address sub-signal CAB<x> corresponding to the input processing sub-module x. The output terminal of the second NAND gate NAND2 serves as the output terminal of the third logic module 121, and is configured to send the third command/address sub-signal CAB<x> to the buffer module 122.

The buffer module 122 performs drive enhancement processing on the third command/address sub-signal CAB<x> to obtain the first intermediate command/address sub-signal A<x> corresponding to the input processing sub-module x.

As shown in FIG. 5, in some embodiments, the buffer module 122 may include an even quantity of sixth NOT gates NOT6. In FIG. 5, two sixth NOT gates NOT6 are shown, but there may be four, six, or eight sixth NOT gates. This is not specifically limited herein. Because there are an even quantity of the sixth NOT gates NOT6, a level state of a signal is not changed, and only a drive enhancement effect is achieved for the signal, thereby ensuring a drive capability of the signal.

In the power down mode, the command/address control signal PDE_CA11 is in an enabled state (a high level state), and the second inverted signal PDE CA11B is in a low level state. In this case, for the second NAND gate NAND2, regardless of a level state of the initial command/address inversion sub-signal CAA<x>, that is, regardless of a level state of the initial command/address sub-signal CA<x>, the third command/address sub-signal CAB<x> output by the second NAND gate NAND2 is always in a high level state (a second level state), so that the first intermediate command/address sub-signal A<x> obtained by the buffer module 122 after performing drive enhancement processing also remains in a high level state. Therefore, in the power down mode, the first intermediate command/address sub-signal A<x> output by the input processing sub-module x is set to a second level state.

In the normal mode, the command/address control signal PDE_CA11 is in a disabled state (a low level state), and the second inverted signal PDE_CA11B is in a high level state. In this case, for the second NAND gate NAND2, the third command/address sub-signal CAB<x> output by the second NAND gate NAND2 is in the opposite level state to the initial command/address inversion sub-signal CAA<x>, that is, the third command/address sub-signal CAB<x> output by the second NAND gate NAND2 is in the same level state as the initial command/address sub-signal CA<x>, so that the first intermediate command/address sub-signal A<x> obtained by the buffer module 122 after performing drive enhancement processing is also in the same level state as the initial command/address sub-signal CA<x>. Therefore, in the normal mode, the level state of the first intermediate command/address sub-signal A<x> output by the input processing sub-module x is the same as the level state of the initial command/address sub-signal CA<x>.

For the third logic module 121, in another specific implementation, reference is made to FIG. 6, which is a schematic diagram of structural composition of still another input processing sub-module according to an embodiment of the present disclosure. As shown in FIG. 6, the third logic module 121 may include a fifth NOT gate NOT5, a tri-state gate TS, and a P-type transistor P1.

An input terminal of the fifth NOT gate NOT5 is configured to receive the command/address control signal PDE CA11, an input terminal of the tri-state gate TS is configured to receive the corresponding initial command/address sub-signal CA<x>, both a control terminal of the tri-state gate TS and an output terminal of the fifth NOT gate NOT5 are connected to a gate terminal of the P-type transistor P1, a first terminal of the P-type transistor P1 is connected to a power supply terminal VDD, a second terminal of the P-type transistor P1 and an output terminal of the tri-state gate TS are connected as the output terminal of the third logic module 121, and are configured to output the corresponding third intermediate command/address sub-signal CAB<x>.

It should be noted that, as shown in FIG. 6, in this implementation, the input terminal of the fifth NOT gate NOT5 serves as the first input terminal of the third logic module 121. The input terminal of the tri-state gate TS serves as the second input terminal of the third logic module 121. The fifth NOT gate NOT5 performs inversion processing on the command/address control signal PDE_CA11 to obtain a third inverted signal PDE_CA11C as a control signal of the P-type transistor P1 and the tri-state gate TS. The second terminal of the P-type transistor P1 and the output terminal of the tri-state gate TS are connected as the output terminal of the third logic module 121.

In the power down mode, the command/address control signal PDE_CA11 is in an enabled state (a high level state), and the third inverted signal PDE_CA11C is in a low level state. In this case, the P-type transistor P1 is turned on, and the tri-state gate TS is turned off, so that the P-type transistor P1 can transmit, to the output terminal of the third logic module 121, a high level provided by the power supply terminal VDD. Therefore, regardless of the level state of the initial command/address sub-signal CA<x>, the level state of the third command/address sub-signal CAB<x> is always a high level state (a second level state) provided by VDD, so that the first intermediate command/address sub-signal A<x> obtained by the buffer module 122 after performing drive enhancement processing also remains in a high level state. Therefore, in the power down mode, the first intermediate command/address sub-signal A<x> output by the input processing sub-module x is set to a second level state.

In the normal mode, the command/address control signal PDE_CA11 is in a disabled state (a low level state), and the third inverted signal PDE_CA11C is in a high level state. In this case, the P-type transistor P1 is cut off, and the tri-state gate TS is turned on, so that the tri-state gate TS can transmit the initial command/address sub-signal CA<x> to the output terminal of the third logic module 121. Therefore, the third command/address sub-signal CAB<x> is in the same level state as the initial command/address sub-signal CA<x>, so that the first intermediate command/address sub-signal A<x> obtained by the buffer module 122 after performing drive enhancement processing is also in the same level state as the initial command/address sub-signal CA<x>. Therefore, in the normal mode, the level state of the first intermediate command/address sub-signal A<x> output by the input processing sub-module x is the same as the level state of the initial command/address sub-signal CA<x>.

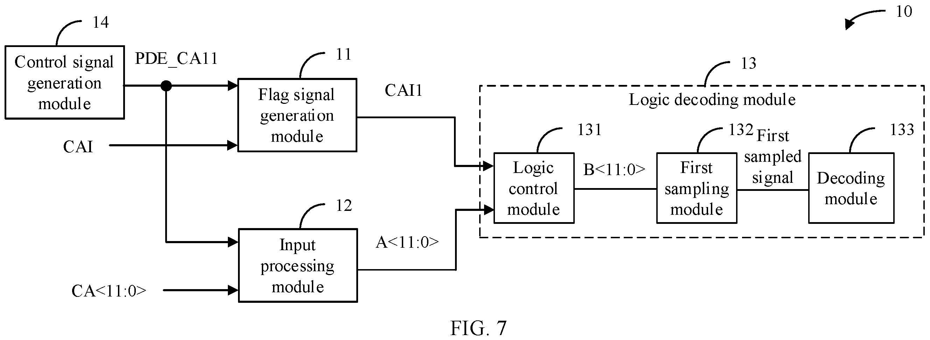

For the logic decoding module 13, reference is made to FIG. 7, which is a schematic diagram of structural composition of another control circuit according to an embodiment of the present disclosure. As shown in FIG. 7, in some embodiments, the logic decoding module 13 includes a logic control module 131, a control terminal of the logic control module 131 is connected to the output terminal of the flag signal generation module 11, and an input terminal of the logic control module 131 is connected to the output terminal of the input processing module 12.

The logic control module 131 is configured to: receive the first intermediate command/address signal A<11:0> and the command/address inversion flag signal CAI1, and perform logical processing based on the command/address inversion flag signal CAI1 and the first intermediate command/address signal A<11:0> to generate a second intermediate command/address signal B<11:0>.

In some embodiments, the logic decoding module 13 further includes a first sampling module 132 and a decoding module 133, an input terminal of the first sampling module 132 is connected to an output terminal of the logic control module 131, and an input terminal of the decoding module 133 is connected to an output terminal of the first sampling module 132.

The first sampling module 132 is configured to perform sampling processing on the second intermediate command/address signal B<11:0> to obtain a first sampled signal.

The decoding module 133 is configured to perform decoding processing on the first sampled signal to obtain the power down mode exit signal.

It should be noted that, as shown in FIG. 7, the logic decoding module 13 includes the logic control module 131, the first sampling module 132, and the decoding module 133. The input terminal of the logic control module 131 serves as the input terminal of the logic decoding module 13, is connected to the output terminal of the input processing module 12, and is configured to receive the first intermediate command/address signal A<11:0>. The control terminal of the logic control module 131 serves as the control terminal of the logic decoding module 13, and is configured to receive the command/address inversion flag signal CAI1. The command/address inversion flag signal CAI1 is configured to perform logic control on the logic control module 131, so that the logic control module 131 generates the second intermediate command/address signal B<11:0> based on the first intermediate command/address signal A<11:0>, and obtains a command signal such as the power down mode exit signal or the power down mode entry signal through decoding based on the second intermediate command/address signal B<11:0>.

Specifically, the logic control module 131 is configured to: control the second intermediate command/address signal B<11:0> to be in the same level state as the first intermediate command/address signal A<11:0> when the command/address inversion flag signal CAI1 is in a first level state, or control the second intermediate command/address signal B<11:0> to be in the opposite level state to the first intermediate command/address signal A<11:0> when the command/address inversion flag signal CAI1 is in a second level state.

It should be noted that a function of the logic control module 131 (also referred to as CAI logic) is as follows: B<11:0>=A<11:0> when the command/address inversion flag signal CAI1 is at a low level, and B<11:0> is equal to an inverted signal of A<11:0> when the command/address inversion flag signal CAI1 is at a high level.

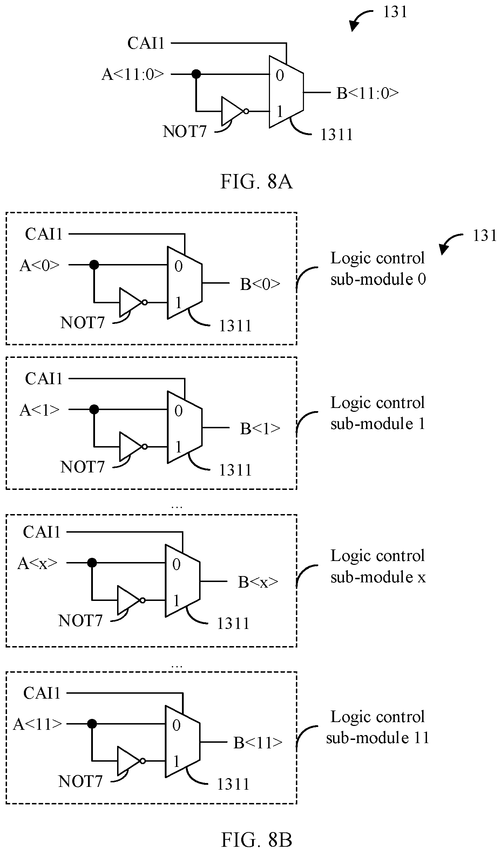

It should be further noted that the logic control module 131 may be implemented by a selector and a NOT gate. FIG. 8A is a schematic diagram of structural composition of a logic control module according to an embodiment of the present disclosure. As shown in FIG. 8A, the logic control module 131 includes a seventh NOT gate NOT7 and a selector 1311.

Both an input terminal of the seventh NOT gate NOT7 and a first input terminal (0) of the selector 1311 are configured to receive the first intermediate command/address signal A<11:0>. An output terminal of the seventh NOT gate NOT7 is connected to a second input terminal (1) of the selector 1311.

A control terminal of the selector 1311 is configured to receive the command/address inversion flag signal CAI1. An output terminal of the selector 1311 is configured to output the second intermediate command/address signal B<11:0>.

As shown in FIG. 8A, the input terminal of the seventh NOT gate NOT7 and the first input terminal of the selector 1311 are connected as the input terminal of the logic control module 131, and are configured to receive the first intermediate command/address signal A<11:0>. The control terminal of the selector 1311 serves as the control terminal of the logic control module 131, and is configured to receive the command/address inversion flag signal CAI1. The seventh NOT gate NOT7 is configured to perform inversion processing on the first intermediate command/address signal A<11:0> to obtain an inverted signal of the first intermediate command/address signal, and provide the inverted signal to the second input terminal of the selector 1311. When the command/address inversion flag signal CAI1 is in a first level state (a low level state), the first input terminal of the selector 1311 is enabled, and the second input terminal thereof is disabled, so that the first intermediate command/address signal A<11:0> is selected for transmission to obtain the second intermediate command/address signal B<11:0>. Therefore, the second intermediate command/address signal B<11:0> obtained at this time is in the same level state as the first intermediate command/address signal A<11:0>. When the command/address inversion flag signal CAI1 is in a second level state (a high level state), the second input terminal of the selector 1311 is enabled, and the first input terminal thereof is disabled, so that the inverted signal of the first intermediate command/address signal is selected for transmission to obtain the second intermediate command/address signal B<11:0>. Therefore, the second intermediate command/address signal B<11:0> obtained at this time is in the opposite level state to the first intermediate command/address signal A<11:0>.

Further, the first intermediate command/address signal A<11:0> may include N bits of first intermediate command/address sub-signals, the second intermediate command/address signal B<11:0> may include N bits of second intermediate command/address sub-signals, and N is a positive integer. Correspondingly, the logic control module 131 includes N logic control sub-modules, and the N logic control sub-modules are respectively in a one-to-one correspondence with both the N bits of first intermediate command/address sub-signals and the N bits of second intermediate command/address sub-signals. FIG. 8B is a schematic diagram of structural composition of another logic control module according to an embodiment of the present disclosure. As shown in FIG. 8B, any logic control sub-module x includes a seventh NOT gate NOT7 and a selector 1311.

Both an input terminal of the seventh NOT gate NOT7 and a first input terminal of the selector 1311 are configured to receive the corresponding first intermediate command/address sub-signal A<x>, an output terminal of the seventh NOT gate NOT7 is connected to a second input terminal of the selector 1311, a control terminal of the selector 1311 is configured to receive the command/address inversion flag signal CAI1, and an output terminal of the selector 1311 is configured to output the corresponding second intermediate command/address sub-signal B<x>. x is an integer greater than or equal to 0 and less than N.

As shown in FIG. 8B, N=12 is still taken as an example. The logic control module 131 includes 12 logic control sub-modules: a logic control sub-module 0, a logic control sub-module 1, ..., and a logic control sub-module 11. In the any logic control sub-module x, the input terminal of the seventh NOT gate NOT7 and the first input terminal of the selector 1311 are connected as the input terminal of the logic control sub-module x, are connected to the output terminal of the input processing module 12, and are configured to receive the first intermediate command/address sub-signal A<x>. The control terminal of the selector 1311 serves as the control terminal of the logic control sub-module x, and is configured to receive the command/address inversion flag signal CAI1. The seventh NOT gate NOT7 is configured to perform inversion processing on the first intermediate command/address sub-signal A<x> to obtain an inverted signal of the first intermediate command/address sub-signal, and provide the inverted signal to the second input terminal of the selector 1311. When the command/address inversion flag signal CAI1 is in a first level state (a low level state), the first input terminal of the selector 1311 is enabled, and the second input terminal thereof is disabled, so that the first intermediate command/address sub-signal A<x> is selected for transmission to obtain the second intermediate command/address sub-signal B<x>. Therefore, the second intermediate command/address sub-signal B<x> obtained at this time is in the same level state as the first intermediate command/address sub-signal A<x>. When the command/address inversion flag signal CAI1 is in a second level state (a high level state), the second input terminal of the selector 1311 is enabled, and the first input terminal thereof is disabled, so that the inverted signal of the first intermediate command/address sub-signal is selected for transmission to obtain the second intermediate command/address sub-signal B<x>. Therefore, the second intermediate command/address sub-signal B<x> obtained at this time is in the opposite level state to the first intermediate command/address sub-signal A<x>.

The logic control module 131 sends the obtained second intermediate command/address signal B<11:0> to the first sampling module 132, so that the first sampling module 132 performs sampling processing to obtain the first sampled signal, and sends the first sampled signal to the decoding module 133. The decoding module 133 performs decoding processing on the first sampled signal to obtain the power down mode exit signal or the power down mode entry signal. The first sampling module 132 may be implemented by a D flip-flop, and a working manner of the decoding module 133 is the same as a working manner of an existing decoding circuit. Details are not described herein again.

That is, the logic control module 131 may include one seventh NOT gate NOT7 and one selector 1311 (as shown in FIG. 8A), to successively obtain N second intermediate command/address sub-signals after N first intermediate command/address sub-signals are successively processed. Alternatively, the logic control module 131 may include N logic control sub-modules, and each of the logic control sub-modules includes one seventh NOT gate NOT7 and one selector 1311 (as shown in FIG. 8B), to obtain N corresponding second intermediate command/address sub-signals obtained after N first intermediate command/address sub-signals are respectively processed. Similarly, the first sampled signal may also include N first sampled sub-signals. The first sampling module 132 may include one D flip-flop, to successively sample the N second intermediate command/address sub-signals to successively obtain N corresponding first sampled sub-signals. Alternatively, the first sampling module 132 may include N D flip-flops, to respectively sample the N second intermediate command/address sub-signals to obtain the N corresponding first sampled sub-signals. The N first sampled sub-signals are provided to the decoding module 133. The decoding module 133 completes decoding based on the N first sampled sub-signals in combination with a chip select signal, to obtain the command signal.

For example, corresponding to the foregoing Table 1 and related descriptions, when the command/address control signal PDE_CA11 is at a high level, second intermediate command/address sub-signals corresponding to CA<0> to CA<4> are set to a high level, and the logic decoding module 13 performs decoding processing in response to the chip select signal CS based on the command/address signals, to output the power down mode exit signal PDX. When the command/address control signal PDE_CA11 is at a low level, the logic decoding module 13 performs decoding based on the second intermediate command/address signal B<11:0> corresponding to CA<11 :0> to obtain another command signal. Therefore, it is ensured that in the normal mode and the power down mode, various required corresponding command signals can be successfully obtained through decoding.

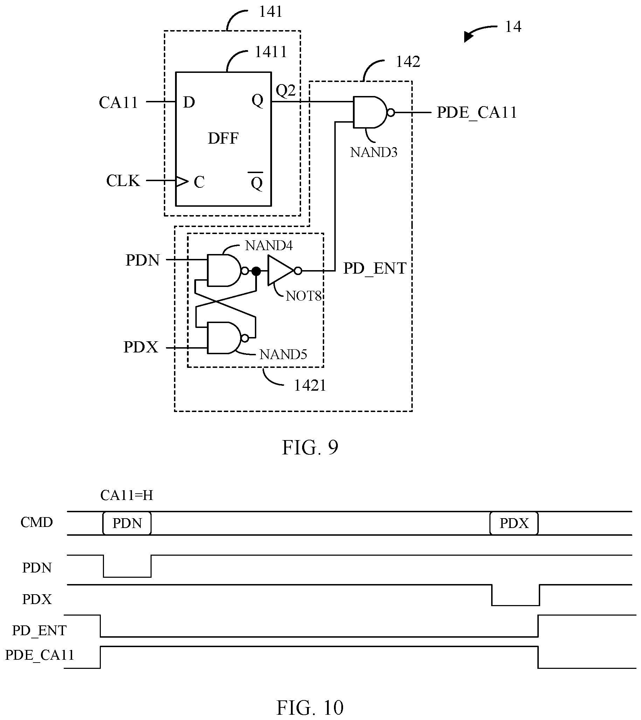

Further, as shown in FIG. 7, the control circuit 10 further includes a control signal generation module 14, and the control signal generation module 14 is configured to generate the command/address control signal PDE _CA11. For the control signal generation module 14, reference is made to FIG. 9, which is a schematic diagram of structural composition of a control signal generation module according to an embodiment of the present disclosure. As shown in FIG. 9, in some embodiments, the second intermediate command/address signal B<11:0> includes N bits of second intermediate command/address sub-signals, the control signal generation module 14 is configured to receive a target command/address signal CA11, the target command/address signal is an nth bit of second intermediate command/address sub-signal in the N bits of second intermediate command/address sub-signals B<11:0>, and n is a positive integer less than or equal to N.

The control signal generation module 14 is further configured to: receive a clock signal CLK, the power down mode entry signal PDN, and the power down mode exit signal PDX, perform sampling processing on the target command/address signal CA11 based on the clock signal CLK to generate a second sampled signal Q2, and perform logical processing based on the second sampled signal Q2, the power down mode entry signal PDN, and the power down mode exit signal PDX to generate the command/address control signal PDE_CA11.

It should be noted that the control signal generation module 14 is connected to the logic control module 131. The target command/address signal may indicate whether the input processing sub-module can normally receive the initial command/address sub-signal. If the target command/address signal is at a low level, it indicates that input processing sub-modules corresponding to CA<0> to CA<4> can normally receive corresponding initial command/address sub-signals, so that the control circuit 10 may obtain PDX through decoding based on each initial command/address signal. If the target command/address signal is at a high level, it indicates that input processing sub-modules corresponding to CA<0> to CA<4> cannot receive corresponding initial command/address sub-signals. In this case, B<0> to B<4> are set to a high level, so that PDX is obtained through decoding. Herein, that the target command/address signal is B<11> (also denoted as CA11) in B<11:0> is taken as an example for description. However, this is not specifically limited.

It should be further noted that, corresponding to the first intermediate command/address signal A<11:0>, the second intermediate command/address signal B<11:0> may also include N bits of second intermediate command/address sub-signals. For example, N=12 and n=12. The 12 bits of second intermediate command/address sub-signals are respectively B<0>, B<1>, B<2>, ..., and B<11>, and the nth bit of second intermediate command/address sub-signal B<11> is the target command/address signal CA11. It may be understood that, corresponding to the N bits of second intermediate command/address sub-signals B<11:0>, the N logic control sub-modules in the logic control module 131 each receive the command/address inversion flag signal CAI1 and a corresponding first intermediate command/address sub-signal, and output a corresponding second intermediate command/address sub-signal. In this case, an input terminal of the control signal generation module 14 is connected to an nth logic control sub-module, and is configured to receive the target command/address signal CA11 output by the nth logic control sub-module.

The control signal generation module 14 is configured to: control the command/address control signal PDE_CA11 to be in an enabled state when in the power down mode, and control the command/address control signal PDE_CA11 to be in a disabled state when in the normal mode.

As shown in FIG. 9, in some embodiments, the control signal generation module 14 includes a second sampling module 141 and a fourth logic module 142.

The second sampling module 141 is configured to: receive the target command/address signal CA11 and the clock signal CLK, and perform sampling processing on the target command/address signal CA11 based on the clock signal CLK to obtain the second sampled signal Q2.

The fourth logic module 142 is configured to: receive the power down mode entry signal PDN, the power down mode exit signal PDX, and the second sampled signal Q2, generate a power down mode enable signal PD_ENT based on the power down mode entry signal PDN and the power down mode exit signal PDX, and perform a logical operation based on the second sampled signal Q2 and the power down mode enable signal PD_ENT to generate the command/address control signal PDE_CA11.

The power down mode enable signal PD_ENT in a valid state is generated when the power down mode entry signal PDN is in a valid state, so that the command/address control signal PDE_CA11 is in an enabled state; and the power down mode enable signal PD_ENT in an invalid state is generated when the power down mode exit signal PDX is in a valid state, so that the command/address control signal PDE_CA11 is in a disabled state.

It should be noted that, as shown in FIG. 9, in the control signal generation module 14, an input terminal of the second sampling module 141 is configured to receive the target command/address signal CA11, a clock terminal of the second sampling module 141 is configured to receive the clock signal CLK, and an output terminal of the second sampling module 141 is connected to an input terminal of the fourth logic module 142. The second sampling module 141 performs sampling processing on the target command/address signal CA11 based on the clock signal CLK to obtain the second sampled signal Q2, and sends the second sampled signal Q2 to the fourth logic module 142.

The fourth logic module 142 further includes two other input terminals, respectively configured to receive the power down mode entry signal PDN and the power down mode exit signal PDX, and an output terminal of the fourth logic module 142 is configured to output the command/address control signal PDE_CA11.

In some embodiments, as shown in FIG. 9, the second sampling module 141 includes a first D flip-flop 1411, and the fourth logic module 142 includes a latch module 1421 and a third NAND gate NAND3.

An input terminal D of the first D flip-flop 1411 is configured to receive the target command/address signal CA11, a clock terminal C of the first D flip-flop is configured to receive the clock signal CLK, an output terminal Q of the first D flip-flop is connected to a first input terminal of the third NAND gate NAND3, and the output terminal of the first D flip-flop 1411 is configured to output the second sampled signal Q2.

A first input terminal of the latch module 1421 is configured to receive the power down mode entry signal PDN, a second input terminal of the latch module 1421 is configured to receive the power down mode exit signal PDX, and an output terminal of the latch module 1421 is configured to output the power down mode enable signal PD_ENT.

A second input terminal of the third NAND gate NAND3 is connected to the output terminal of the latch module 1421, and an output terminal of the third NAND gate NAND3 is configured to output the command/address control signal PDE_CA11.

It should be noted that the second sampling module 141 may be implemented by a D flip-flop (DFF). For the first D flip-flop 1411 shown in FIG. 9, the input terminal D of the first D flip-flop 1411 serves as the input terminal of the second sampling module 141, the clock terminal C of the first D flip-flop 1411 serves as the clock terminal of the second sampling module 141, and the output terminal Q of the first D flip-flop 1411 serves as the output terminal of the second sampling module 141. Two input terminals of the latch module 1421 serve as two input terminals of the fourth logic module 142, and are respectively configured to: receive the power down mode entry signal PDN and the power down mode exit signal PDX, obtain the power down mode enable signal PD_ENT based on the power down mode entry signal PDN and the power down mode exit signal PDX, and send the power down mode enable signal PD_ENT to the second input terminal of the third NAND gate NAND3. The first input terminal of the third NAND gate NAND3 serves as another input terminal of the fourth logic module 142, and is connected to the output terminal of the first D flip-flop.

When the power down mode entry signal PDN is in a valid state and the power down mode exit signal PDX is in an invalid state, the latch module 1421 may obtain the power down mode enable signal PD_ENT in a valid state, which passes through the third NAND gate NAND3, so that the command/address control signal PDE_CA11 is in an enabled state. When the power down mode exit signal PDX is in a valid state and the power down mode entry signal PDN is in an invalid state, the latch module 1421 may obtain the power down mode enable signal PD_ENT in an invalid state, which passes through the third NAND gate NAND3, so that the command/address control signal PDE_CA11 is in a disabled state.

It should be further noted that in this embodiment of the present disclosure, the power down mode entry signal PDN, the power down mode exit signal PDX, and the power down mode enable signal PD_ENT are described through an example in which the valid state of the signal is the logic 0 indicating the low level and the invalid state of the signal is the logic 1 indicating the high level. However, the valid state may be the logic 1 indicating the high level, and the invalid state may be the logic 0 indicating the low level. This is not specifically limited.

Further, for the latch module 1421, in some embodiments, as shown in FIG. 9, the latch module 1421 includes a fourth NAND gate NAND4, a fifth NAND gate NAND5, and an eighth NOT gate NOT8.

A first input terminal of the fourth NAND gate NAND4 is configured to receive the power down mode entry signal PDN, a second input terminal of the fourth NAND gate NAND4 is connected to an output terminal of the fifth NAND gate NAND5, an output terminal of the fourth NAND gate NAND4 is separately connected to a first input terminal of the fifth NAND gate NAND5 and an input terminal of the eighth NOT gate NOT8, a second input terminal of the fifth NAND gate NAND5 is configured to receive the power down mode exit signal PDX, and an output terminal of the eighth NOT gate NOT8 is connected to the second input terminal of the third NAND gate NAND3.

It should be noted that, as shown in FIG. 9, the first input terminal of the fourth NAND gate NAND4 and the second input terminal of the fifth NAND gate NAND5 respectively serve as two input terminals of the latch module 1421, and the output terminal of the eighth NOT gate NOT8 serves as the output terminal of the latch module 1421.

The fourth NAND gate NAND4 and the fifth NAND gate NAND5 form a latch. A port receiving the power down mode entry signal PDN serves as a set terminal S of the latch, and a port receiving the power down mode exit signal PDX serves as a reset terminal R of the latch. The latch performs latch processing based on the power down mode entry signal PDN and the power down mode exit signal PDX to obtain a latch signal, so that the eighth NOT gate NOT8 performs inversion processing on the latch signal to obtain the power down mode enable signal PD_ENT.

FIG. 10 is a schematic diagram of signal timing of a corresponding control circuit. As shown in FIG. 10, when the target command/address signal CA11 is at a high level (H), the control circuit is in the power down mode in a time period from the power down mode entry signal PDN being in a valid state (a low level) to the power down mode exit signal PDX being in a valid state (a low level). In this time period, the power down mode enable signal PD_ENT in a valid state (a low level) is generated, to obtain the command/address control signal PDE_CA11 in an enabled state (a high level). Further, the command/address control signal PDE _CA11 at a high level causes the command/address inversion flag signal CAI1 to be set to a first level state, and causes the first intermediate command/address signal to be set to a second level state. Further, decoding is performed by the logic decoding module 13 to generate the power down mode exit signal PDX.

For example, Table 2 shows a level state of a related signal and an output of each module.

**Table 2**

| CMD | CA11 | CAI | Buffers of CA<0:4> | Other buffers | |
|---|---|---|---|---|---|
| PDE | H | Disabled | Off | Off | CA<0:4> is set to a default value: 11111 |
| PDE | L | Disabled | On | Off | PDX depends on external CA |
| PDE | H | Enabled | Off | Off | CA<0:4> is set to a default value: 11111 |
| PDE | L | Enabled | On | Off | PDX depends on external CA |

As shown in Table 2, L represents the low level state, and H represents the high level state. Generally, when the target command/address signal CA11 is in a high level state, the buffers (input processing sub-modules) of the initial command/address signal CA<0:4> are all turned off regardless of whether the initial inversion flag signal CAI is enabled or disabled (regardless of 1 or 0). In this case, first intermediate command/address sub-signals corresponding to the initial command/address signal CA<0:4> should all be set to the default value 111111 by the circuit. When the target command/address signal CA11 is in a low level state, the buffers (input processing sub-modules) of the initial command/address signal CA<0:4> are all turned on. In this case, level states of first intermediate command/address sub-signals corresponding to the initial command/address signal CA<0:4> depend on a level state of the initial command/address signal CA<0:4>. In addition, the chip has a mirror (MIR) pin. When a valid signal is received, CA<0> to CA<4> are configured to decode an MIR command, and a mirror function is enabled, so that the memory is in a mirror mode. In the mirror mode, information is exchanged between CA<0> and CA<1>, information is exchanged between CA<2> and CA<3>, and information is exchanged between CA<4> and CA<5>. In this case, control manners of the input processing sub-modules corresponding to the initial command/address sub-signals are correspondingly replaced.

In short, when the control circuit is in the power down mode, in this embodiment of the present disclosure, the command/address control signal PDE_CA11 may be configured to control the level state of the command/address inversion flag signal CAI1 output by the CAI buffer (namely, the flag signal generation module 11). When the chip enters the power down mode, the command/address control signal PDE_CA11 changes to a high level, and the output of the flag signal generation module 11 is set, so that the command/address inversion flag signal CAI1 output by the flag signal generation module is always 0 (regardless of whether the initial inversion flag signal CAI is 0 or 1). In this case, B<11:0>=A<11:0>. In addition, when the command/address control signal PDE_CA11 is at a high level, all CA buffers (input processing sub-modules in the input processing module 12) are turned off, and the output first intermediate command/address sub-signals are all set to a high level, so that the power down mode exit signal PDX is correctly obtained through decoding in combination with the chip select signal CS. Therefore, this ensures that the power down mode exit signal can be successfully obtained through decoding, thereby reducing power consumption and implementing a normal function in the power down mode of the memory (such as DDR5).

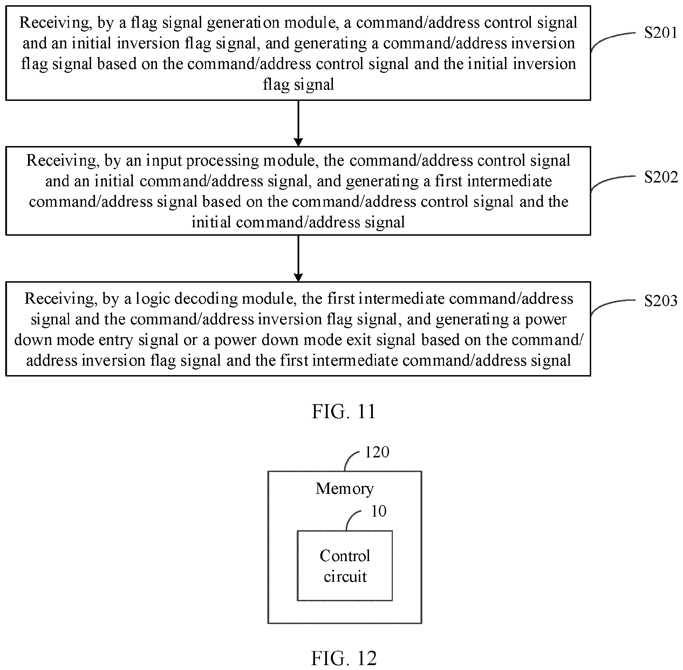

In another embodiment of the present disclosure, reference is made to FIG. 11, which is a schematic flowchart of a control method according to an embodiment of the present disclosure. As shown in FIG. 11, the method may include the steps as follows.

In the step of S201, a command/address control signal and an initial inversion flag signal are received by a flag signal generation module, and a command/address inversion flag signal is generated based on the command/address control signal and the initial inversion flag signal.

In the step of S202, the command/address control signal and an initial command/address signal are received by an input processing module, and a first intermediate command/address signal is generated based on the command/address control signal and the initial command/address signal.

In the step of S203, the first intermediate command/address signal and the command/address inversion flag signal are received by a logic decoding module, and a power down mode entry signal or a power down mode exit signal is generated based on the command/address inversion flag signal and the first intermediate command/address signal.

In some embodiments, that a command/address inversion flag signal is generated based on the command/address control signal and the initial inversion flag signal may include the step as follows.

The command/address inversion flag signal is controlled to be in a first level state when the command/address control signal is in an enabled state, and a level state of the command/address inversion flag signal is determined based on the initial inversion flag signal when the command/address control signal is in a disabled state.

It indicates that a chip including the control circuit is in a power down mode when the command/address control signal is in an enabled state, or it indicates that a chip including the control circuit is in a normal mode when the command/address control signal is in a disabled state.

In some embodiments, that the command/address inversion flag signal is controlled to be in a first level state when the command/address control signal is in an enabled state, and a level state of the command/address inversion flag signal is determined based on the initial inversion flag signal when the command/address control signal is in a disabled state may include the steps as follows.

The command/address control signal is received by a first logic module, and inversion processing is performed on the command/address control signal to obtain a first inverted signal.

The first inverted signal and the initial inversion flag signal are received by a second logic module, logical processing is performed on the first inverted signal and the initial inversion flag signal, the command/address inversion flag signal in a first level state is generated and output in the power down mode, and the command/address inversion flag signal in the same level state as the initial inversion flag signal is generated and output in the normal mode.

In some embodiments, that a first intermediate command/address signal is generated based on the command/address control signal and the initial command/address signal may include the step as follows.

The first intermediate command/address signal is controlled to be in a second level state when the command/address control signal is in an enabled state, and a level state of the first intermediate command/address signal is determined based on the initial command/address signal when the command/address control signal is in a disabled state.

It indicates that the chip including the control circuit is in the power down mode when the command/address control signal is in an enabled state, or it indicates that the chip including the control circuit is in the normal mode when the command/address control signal is in a disabled state.

In some embodiments, the initial command/address signal includes N bits of initial command/address sub-signals, the first intermediate command/address signal includes N bits of first intermediate command/address sub-signals, and N is a positive integer. That a first intermediate command/address signal is generated based on the command/address control signal and the initial command/address signal may include the step as follows.

The command/address control signal and the corresponding initial command/address sub-signal are separately received by N input processing sub-modules, and the corresponding first intermediate command/address sub-signal is generated based on the command/address control signal and the corresponding initial command/address sub-signal.

In some embodiments, that the corresponding first intermediate command/address sub-signal is generated based on the command/address control signal and the corresponding initial command/address sub-signal may include the steps as follows.

The command/address control signal and the corresponding initial command/address sub-signal are received by a third logic module, and logical processing is performed on the command/address control signal and the corresponding initial command/address sub-signal to generate a third intermediate command/address sub-signal.

The third intermediate command/address sub-signal is received by a buffer module, and drive enhancement processing is performed on the third intermediate command/address sub-signal to obtain the first intermediate command/address sub-signal.

In the power down mode, the first intermediate command/address sub-signal in a second level state is generated and output, and in the normal mode, the first intermediate command/address sub-signal in the same level state as the initial command/address sub-signal is generated and output.

In some embodiments, that a power down mode entry signal or a power down mode exit signal is generated based on the command/address inversion flag signal and the first intermediate command/address signal may include the steps as follows.

The first intermediate command/address signal and the command/address inversion flag signal are received by a logic control module, and logical processing is performed based on the command/address inversion flag signal and the first intermediate command/address signal to generate a second intermediate command/address signal.

The second intermediate command/address signal is received by a first sampling module, to perform sampling processing on the second intermediate command/address signal to obtain a first sampled signal.

The first sampled signal is received by a decoding module, to perform decoding processing on the first sampled signal to obtain the power down mode exit signal.

In some embodiments, the second intermediate command/address signal includes N bits of second intermediate command/address sub-signals, and the method may further include the step as follows.

A clock signal, the power down mode entry signal, and the power down mode exit signal are received by a control signal generation module, sampling processing is performed on the target command/address signal based on the clock signal to generate a second sampled signal, and logical processing is performed based on the second sampled signal, the power down mode entry signal, and the power down mode exit signal to generate the command/address control signal.

The target command/address signal is an nth bit of second intermediate command/address sub-signal in the N bits of second intermediate command/address sub-signals, and n is a positive integer less than or equal to N.

In some embodiments, the method may further include the step as follows.

The second intermediate command/address signal is controlled to be in the same level state as the first intermediate command/address signal when the command/address inversion flag signal is in a first level state, or the second intermediate command/address signal is controlled to be in the opposite level state to the first intermediate command/address signal when the command/address inversion flag signal is in a second level state.

In some embodiments, that sampling processing is performed on the target command/address signal based on the clock signal to generate a second sampled signal, and logical processing is performed based on the second sampled signal, the power down mode entry signal, and the power down mode exit signal to generate the command/address control signal may include the steps as follows.

The target command/address signal and the clock signal are received by a second sampling module, and sampling processing is performed on the target command/address signal based on the clock signal to obtain the second sampled signal.

The power down mode entry signal, the power down mode exit signal, and the second sampled signal are received by a fourth logic module, a power down mode enable signal is generated based on the power down mode entry signal and the power down mode exit signal, and a logical operation is performed based on the second sampled signal and the power down mode enable signal to generate the command/address control signal.

The power down mode enable signal in a valid state is generated when the power down mode entry signal is in a valid state, so that the command/address control signal is in an enabled state; and the power down mode enable signal in an invalid state is generated when the power down mode exit signal is in a valid state, so that the command/address control signal is in a disabled state.

It should be noted that this embodiment of the present disclosure is applied to the control circuit 10 provided in the foregoing embodiment. For details not disclosed in this embodiment of the present disclosure, reference is made to the descriptions of the foregoing embodiment for understanding.

This embodiment of the present disclosure provides a control method. The command/address control signal is configured to separately control the command address/inversion flag signal output by the flag signal generation module and the first intermediate command/address signal output by the input processing module. This ensures that the logic decoding module can successfully obtain a required command signal through decoding regardless of whether the initial inversion flag signal is enabled, especially in a power down mode, ensures that the power down mode exit signal can be successfully obtained through decoding, to ensure that the circuit can successfully exit the power down mode, thereby ensuring normal working of the memory, and improving memory performance.

In still another embodiment of the present disclosure, reference is made to FIG. 12, which is a schematic diagram of structural composition of a memory 120 according to an embodiment of the present disclosure. As shown in FIG. 12, the memory 120 may include at least the control circuit 10 described in any one of the foregoing embodiments.

In some embodiments, the memory 120 is a semiconductor memory, such as a dynamic random access memory (DRAM) chip.

In this embodiment of the present disclosure, the DRAM may not only meet a memory specification such as DDR, DDR2, DDR3, DDR4, and DDR5, but also meet a memory specification such as LPDDR, LPDDR2, LPDDR3, LPDDR4, and LPDDR5. This is not limited herein.

In this embodiment of the present disclosure, because the memory 120 includes the control circuit 10 described in the foregoing embodiment, it can be ensured that the power down mode exit signal can be successfully obtained through decoding when CAI is enabled, so that the memory can successfully exit the power down mode, thereby facilitating normal working of the memory, and improving memory performance.

The foregoing descriptions are merely example embodiments of the present disclosure, and are not intended to limit the protection scope of the present disclosure.

It should be noted that in the present disclosure, the terms "include", "comprise", or any other variant thereof are intended to cover non-exclusive inclusion, so that a procedure, method, article, or apparatus including a series of elements includes not only those elements but also other elements not expressly listed, or further includes elements inherent to such a procedure, method, article, or apparatus. An element preceded by "includes a ..." does not, without more constraints, preclude the presence of additional identical elements in the procedure, method, article, or apparatus including the element.

The sequence numbers of the foregoing embodiments of the present disclosure are merely for the purpose of description, and do not represent priorities of the embodiments.

The methods disclosed in the several method embodiments provided in the present disclosure may be randomly combined when there is no conflict, to obtain new method embodiments.

The features disclosed in the several product embodiments provided in the present disclosure may be randomly combined when there is no conflict, to obtain new product embodiments.

The features disclosed in the several method or device embodiments provided in the present disclosure may be randomly combined when there is no conflict, to obtain new method embodiments or new device embodiments.

The foregoing descriptions are merely specific implementations of the present disclosure, but are not intended to limit the protection scope of the present disclosure. Any variation or replacement readily figured out by a person skilled in the art within the technical scope disclosed in the present disclosure shall fall within the protection scope of the present disclosure. Therefore, the protection scope of the present disclosure shall be subject to the protection scope of the claims.

### Industrial applicability

This embodiment provides a control circuit, a control method, and a memory. In the control circuit, a flag signal generation module is configured to: receive a command/address control signal and an initial inversion flag signal, and generate a command/address inversion flag signal based on the command/address control signal and the initial inversion flag signal; an input processing module is configured to receive the command/address control signal and an initial command/address signal, and generate a first intermediate command/address signal based on the command/address control signal and the initial command/address signal; and a logic decoding module is separately connected to the flag signal generation module and the input processing module, and is configured to: receive the first intermediate command/address signal and the command/address inversion flag signal, and generate a power down mode entry signal or a power down mode exit signal based on the command/address inversion flag signal and the first intermediate command/address signal. In this way, the command/address control signal is configured to separately control the command address/inversion flag signal output by the flag signal generation module and the first intermediate command/address signal output by the input processing module. This ensures that the logic decoding module can successfully obtain a required command signal through decoding regardless of whether the initial inversion flag signal is enabled, especially in a power down mode, ensures that the power down mode exit signal can be successfully obtained through decoding, to ensure that the circuit can successfully exit the power down mode, thereby ensuring normal working of the memory, and improving memory performance.

## Claims

1. A control circuit (10), comprising:
a flag signal generation module (11), configured to: receive a command/address control signal and an initial inversion flag signal, and generate a command/address inversion flag signal based on the command/address control signal and the initial inversion flag signal;
an input processing module (12), configured to: receive the command/address control signal and an initial command/address signal, and generate a first intermediate command/address signal based on the command/address control signal and the initial command/address signal; and
a logic decoding module (13), separately connected to the flag signal generation module (11) and the input processing module (12), and configured to: receive the first intermediate command/address signal and the command/address inversion flag signal, and generate a power down mode entry signal or a power down mode exit signal based on the command/address inversion flag signal and the first intermediate command/address signal.

2. The control circuit (10) according to claim 1, wherein
the flag signal generation module (11) is configured to: control the command/address inversion flag signal to be in a first level state when the command/address control signal is in an enabled state, and determine a level state of the command/address inversion flag signal based on the initial inversion flag signal when the command/address control signal is in a disabled state; and
it indicates that a chip comprising the control circuit is in a power down mode when the command/address control signal is in an enabled state, or it indicates that a chip comprising the control circuit is in a normal mode when the command/address control signal is in a disabled state.

3. The control circuit (10) according to claim 2, wherein the flag signal generation module (11) comprises a first logic module (111) and a second logic module (112),
the first logic module (111) being configured to: receive the command/address control signal, and perform inversion processing on the command/address control signal to obtain a first inverted signal; and
the second logic module (112) being configured to: receive the first inverted signal and the initial inversion flag signal, perform logical processing on the first inverted signal and the initial inversion flag signal, generate and output, in the power down mode, the command/address inversion flag signal in a first level state, and generate and output, in the normal mode, the command/address inversion flag signal in a same level state as the initial inversion flag signal.

4. The control circuit (10) according to claim 3, wherein the first logic module (111) comprises a first NOT gate (NOT1), and the second logic module (112) comprises a first NAND gate (NAND1) and a second NOT gate (NOT2),
an input terminal of the first NOT gate (NOT1) being configured to receive the command/address control signal, an output terminal of the first NOT gate (NOT 1) being connected to a first input terminal of the first NAND gate (NAND1), a second input terminal of the first NAND gate (NAND1) being configured to receive the initial inversion flag signal, an output terminal of the first NAND gate (NAND1) being connected to an input terminal of the second NOT gate (NOT2), and an output terminal of the second NOT gate (NOT2) being configured to output the command/address inversion flag signal.

5. The control circuit (10) according to any one of claims 1 to 4, wherein
the input processing module (12) is configured to: control the first intermediate command/address signal to be in a second level state when the command/address control signal is in an enabled state, and determine a level state of the first intermediate command/address signal based on the initial command/address signal when the command/address control signal is in a disabled state; and
it indicates that the chip comprising the control circuit is in the power down mode when the command/address control signal is in an enabled state, or it indicates that the chip comprising the control circuit is in the normal mode when the command/address control signal is in a disabled state.

6. The control circuit (10) according to claim 5, wherein the initial command/address signal comprises N bits of initial command/address sub-signals, the first intermediate command/address signal comprises N bits of first intermediate command/address sub-signals, N is a positive integer, the input processing module (12) comprises N input processing sub-modules, and the N input processing sub-modules are respectively in a one-to-one correspondence with both the N bits of initial command/address sub-signals and the N bits of first intermediate command/address sub-signals; and
each of the input processing sub-modules is configured to: receive the command/address control signal and the corresponding initial command/address sub-signal, and generate the corresponding first intermediate command/address sub-signal based on the command/address control signal and the corresponding initial command/address sub-signal.

7. The control circuit (10) according to claim 6, wherein each of the input processing sub-modules comprises a third logic module (121) and a buffer module (122),
the third logic module (121) being configured to: receive the command/address control signal and the corresponding initial command/address sub-signal, and perform logical processing on the command/address control signal and the corresponding initial command/address sub-signal to generate a third intermediate command/address sub-signal; and
the buffer module (122) being configured to perform drive enhancement processing on the third intermediate command/address sub-signal to obtain the first intermediate command/address sub-signal, wherein
in the power down mode, the first intermediate command/address sub-signal in a second level state is generated and output, and in the normal mode, the first intermediate command/address sub-signal in a same level state as the initial command/address sub-signal is generated and output.

8. The control circuit (10) according to claim 7, wherein the third logic module (121) comprises a third NOT gate (NOT3), a fourth NOT gate (NOT4), and a second NAND gate (NAND2),
an input terminal of the third NOT gate (NOT3) being configured to receive the command/address control signal, and an output terminal of the third NOT gate (NOT3) being connected to a first input terminal of the second NAND gate (NAND2);
an input terminal of the fourth NOT gate (NOT4) being configured to receive the corresponding initial command/address sub-signal, and an output terminal of the fourth NOT gate (NOT4) being connected to a second input terminal of the second NAND gate (NAND2); and
an output terminal of the second NAND gate (NAND2) being configured to output the third intermediate command/address sub-signal.

9. The control circuit (10) according to claim 7, wherein the third logic module (121) comprises a fifth NOT gate (NOT5), a tri-state gate (TS), and a P-type transistor (P1),
an input terminal of the fifth NOT gate (NOT5) being configured to receive the command/address control signal, an input terminal of the tri-state gate (TS) being configured to receive the corresponding initial command/address sub-signal, both a control terminal of the tri-state gate (TS) and an output terminal of the fifth NOT gate (NOT5) being connected to a gate terminal of the P-type transistor (P1), a first terminal of the P-type transistor (P1) being connected to a power supply terminal, a second terminal of the P-type transistor (P1) and an output terminal of the tri-state gate (TS) being connected as an output terminal of the third logic module (121), and being configured to output the corresponding third intermediate command/address sub-signal.

10. The control circuit (10) according to any one of claims 7 to 9, wherein the buffer module (122) comprises an even quantity of sixth NOT gates (NOT6) connected in series.

11. The control circuit (10) according to any one of claims 1 to 10, wherein the logic decoding module (13) comprises a logic control module (131), a control terminal of the logic control module (131) is connected to an output terminal of the flag signal generation module (11), and an input terminal of the logic control module (131) is connected to an output terminal of the input processing module (12); and
the logic control module (131) is configured to: receive the first intermediate command/address signal and the command/address inversion flag signal, and perform logical processing based on the command/address inversion flag signal and the first intermediate command/address signal to generate a second intermediate command/address signal.

12. The control circuit (10) according to claim 11, wherein
the logic control module (131) is configured to: control the second intermediate command/address signal to be in a same level state as the first intermediate command/address signal when the command/address inversion flag signal is in a first level state, or control the second intermediate command/address signal to be in an opposite level state to the first intermediate command/address signal when the command/address inversion flag signal is in a second level state.

13. The control circuit (10) according to claim 12, wherein the first intermediate command/address signal comprises N bits of first intermediate command/address sub-signals, the second intermediate command/address signal comprises N bits of second intermediate command/address sub-signals, N is a positive integer, the logic control module (131) comprises N logic control sub-modules, the N logic control sub-modules are respectively in a one-to-one correspondence with both the N bits of first intermediate command/address sub-signals and the N bits of second intermediate command/address sub-signals, and each of the logic control sub-modules comprises a seventh NOT gate (NOT7) and a selector (1311),
both an input terminal of the seventh NOT gate (NOT7) and a first input terminal of the selector (1311) being configured to receive the corresponding first intermediate command/address sub-signal, an output terminal of the seventh NOT gate (NOT7) being connected to a second input terminal of the selector (1311), a control terminal of the selector (1311) being configured to receive the command/address inversion flag signal, and an output terminal of the selector (1311) being configured to output the corresponding second intermediate command/address sub-signal.

14. The control circuit (10) according to claim 11, wherein the logic decoding module (13) further comprises a first sampling module (132) and a decoding module (133), an input terminal of the first sampling module (132) is connected to an output terminal of the logic control module (131), and an input terminal of the decoding module (133) is connected to an output terminal of the first sampling module (132),
the first sampling module (132) being configured to perform sampling processing on the second intermediate command/address signal to obtain a first sampled signal; and
the decoding module (133) being configured to perform decoding processing on the first sampled signal to obtain the power down mode exit signal.

15. The control circuit (10) according to claim 11, wherein the second intermediate command/address signal comprises N bits of second intermediate command/address sub-signals, the control circuit (10) further comprises a control signal generation module (14), the control signal generation module (14) is connected to the logic control module (131) and is configured to receive a target command/address signal, the target command/address signal is an nth bit of second intermediate command/address sub-signal in the N bits of second intermediate command/address sub-signals, and n is a positive integer less than or equal to N; and
the control signal generation module (14) is further configured to: receive a clock signal, the power down mode entry signal, and the power down mode exit signal, perform sampling processing on the target command/address signal based on the clock signal to generate a second sampled signal, and perform logical processing based on the second sampled signal, the power down mode entry signal, and the power down mode exit signal to generate the command/address control signal.

16. The control circuit (10) according to claim 15, wherein the control signal generation module (14) is configured to: control the command/address control signal to be in an enabled state when in the power down mode, and control the command/address control signal to be in a disabled state when in the normal mode.

17. The control circuit (10) according to claim 15, wherein the control signal generation module (14) comprises a second sampling module (141) and a fourth logic module (142),
the second sampling module (141) being configured to: receive the target command/address signal and the clock signal, and perform sampling processing on the target command/address signal based on the clock signal to obtain the second sampled signal; and
the fourth logic module (142) being configured to: receive the power down mode entry signal, the power down mode exit signal, and the second sampled signal, generate a power down mode enable signal based on the power down mode entry signal and the power down mode exit signal, and perform a logical operation based on the second sampled signal and the power down mode enable signal to generate the command/address control signal, wherein
the power down mode enable signal in a valid state is generated when the power down mode entry signal is in a valid state, so that the command/address control signal is in an enabled state; and the power down mode enable signal in an invalid state is generated when the power down mode exit signal is in a valid state, so that the command/address control signal is in a disabled state.

18. The control circuit (10) according to claim 17, wherein the second sampling module (141) comprises a first D flip-flop (1411), and the fourth logic module (142) comprises a latch module (1421) and a third NAND gate (NAND3),
an input terminal of the first D flip-flop (1411) being configured to receive the target command/address signal, a clock terminal of the first D flip-flop (1411) being configured to receive the clock signal, an output terminal of the first D flip-flop (1411) being connected to a first input terminal of the third NAND gate (NAND3), and the output terminal of the first D flip-flop (1411) being configured to output the second sampled signal;
a first input terminal of the latch module (1421) being configured to receive the power down mode entry signal, a second input terminal of the latch module (1421) being configured to receive the power down mode exit signal, and an output terminal of the latch module (1421) being configured to output the power down mode enable signal; and
a second input terminal of the third NAND gate (NAND3) being connected to the output terminal of the latch module (1421), and an output terminal of the third NAND gate (NAND3) being configured to output the command/address control signal.

19. The control circuit (10) according to claim 18, wherein the latch module (1421) comprises a fourth NAND gate (NAND4), a fifth NAND gate (NAND5), and an eighth NOT gate (NOT8),
a first input terminal of the fourth NAND gate (NAND4) being configured to receive the power down mode entry signal, a second input terminal of the fourth NAND gate (NAND4) being connected to an output terminal of the fifth NAND gate (NAND5), an output terminal of the fourth NAND gate (NAND4) being separately connected to a first input terminal of the fifth NAND gate (NANDS) and an input terminal of the eighth NOT gate (NOT8), a second input terminal of the fifth NAND gate (NAND5) being configured to receive the power down mode exit signal, and an output terminal of the eighth NOT gate (NOT8) being connected to the second input terminal of the third NAND gate (NAND3).

20. A control method, comprising:
receiving, by a flag signal generation module (11), a command/address control signal and an initial inversion flag signal, and generating a command/address inversion flag signal based on the command/address control signal and the initial inversion flag signal;
receiving, by an input processing module (12), the command/address control signal and an initial command/address signal, and generating a first intermediate command/address signal based on the command/address control signal and the initial command/address signal; and
receiving, by a logic decoding module (13), the first intermediate command/address signal and the command/address inversion flag signal, and generating a power down mode entry signal or a power down mode exit signal based on the command/address inversion flag signal and the first intermediate command/address signal.

21. A memory (120), comprising the control circuit (10) according to any one of claims 1 to 19.
